# FASCICULE DE BREVET EUROPEEN

(11) **EP 2 345 161 B1**
(45) Date de publication et mention de la délivrance du brevet: **20.02.2019**
(21) Numéro de dépôt: 09783978.1
(22) Date de dépôt: 13.10.2009
(51) Int. Cl.: H03L 7/091, H04L 7/033

(54) **DISPOSITIF DE RECONSTITUTION DE L'HORLOGE D'UN SIGNAL NRZ, ET SYSTEME DE TRANSMISSION ASSOCIE**
EINRICHTUNG ZUM REKONSTRUIEREN DES TAKTS EINES NRZ-SIGNALS UND DIESBEZÜGLICHES ÜBERTRAGUNGSSYSTEM
DEVICE FOR RECONSTRUCTING THE CLOCK OF AN NRZ SIGNAL, AND ASSOCIATED TRANSMISSION SYSTEM

(30) Priorité: 13.10.2008 FR 0856916
(43) Date de publication de la demande: 20.07.2011
(73) Titulaire: Safran Electronics & Defense, 92100 Boulogne-Billancourt (FR)
(72) Inventeur: GUILLOT, François, 75015 Paris (FR)
(74) Mandataire: Regimbeau
(86) Numéro de dépôt international: PCT/EP2009/063345
(87) Numéro de publication internationale: WO 2010/043614

(56) Documents cités:
- EP-A2- 0 502 739
- JP-A- 3 019 520
- JP-A- 58 095 430
- US-A- 5 127 026
- US-A1- 2003 179 842

## Description

Le domaine de l'invention est celui de la transmission de données numériques sur une liaison série en bande de base entre un émetteur et un récepteur reliés par un canal de communication.

L'invention concerne plus précisément un dispositif de reconstitution du signal d'horloge du message série en bande de base transmis sur un tel canal de communication, ainsi qu'un système de transmission de données incorporant un tel dispositif.

Dans les liaisons numériques série en bande de base, il est nécessaire, au niveau du récepteur, d'extraire du signal reçu d'une part les données numériques transmises successivement par ce signal reçu et d'autre part le signal d'horloge correspondant à ces données.

On connaît deux méthodes pour récupérer le rythme binaire du signal reçu.

Selon une première méthode, on émet le signal d'horloge en le superposant au signal de données sur le canal de transmission. Cette première méthode présente l'inconvénient de consommer une partie de la puissance émise, nécessaire au signal, ainsi qu'une partie de la bande passante utile du canal de transmission.

Selon une seconde méthode, on restitue l'horloge à partir des transitions du signal. Il faut donc transmettre des signaux tels que le récepteur puisse trouver de nombreuses transitions, même pour des suites de bits identiques. Cette contrainte exclut l'utilisation du codage NRZ (« Non Return to Zero » désignant le codage « non-retour à zéro »).

Aujourd'hui, les circuits d'extraction d'horloge sont généralement réalisés à partir d'une boucle à verrouillage de phase, dite PLL, qui comprend principalement un comparateur de phase qui délivre un signal de consigne à un oscillateur contrôlé en tension via un filtre de boucle. Une PLL réalise ainsi une adaptation permanente de la phase du signal d'horloge délivré par l'oscillateur à la phase du signal reçu en modifiant légèrement la fréquence de l'oscillateur pour rattraper le décalage de phase éventuel.

Plus précisément, lorsque les signaux (horloge et données) ne sont pas en phase, le comparateur de phase génère une tension d'erreur. Le filtre de boucle filtre cette tension d'erreur et sa tension moyenne pilote directement l'oscillateur. En revanche, lorsque la boucle est verrouillée, les deux signaux sont en phase et aucune tension d'erreur n'est générée.

La publication de la demande de brevet JP3019520-A divulgue un dispositif de reconstitution d'un signal d'horloge d'un signal à cycle arbitraire, comprenant une boucle à verrouillage de phase comprenant un oscillateur contrôlé en tension qui génère le signal d'horloge.

Dans le cas de transmission de données comprenant de longues séries de bits identiques (donc sans transitions, ce qui est en particulier le cas du codage NRZ), aucune tension d'erreur n'est disponible et l'oscillateur est alors susceptible de dériver et de rompre le verrouillage.

Toutefois, outre sa relative simplicité, le codage NRZ présente l'avantage de présenter un spectre relativement restreint ce qui permet d'envisager son utilisation sur des supports à bande étroite car l'occupation spectrale du signal est alors limitée, ou dans des applications nécessitant de minimiser la bande passante occupée par une transmission numérique série. En particulier, le codage NRZ s'avère avantageux dans le cas où l'on utilise une seule ligne de transmission mutualisée pour la transmission de puissance électrique et de données bidirectionnelles entre un émetteur et un récepteur.

L'invention a pour objectif de proposer une technique permettant de reconstituer le signal d'horloge d'un message série en bande de base à partir des transitions du signal, qui présente une très bonne insensibilité aux absences de transitions. Notamment, l'invention vise à permettre la reconstitution de l'horloge à partir des transitions d'un signal NRZ.

A cet effet, l'invention propose, selon un premier aspect, un dispositif de reconstitution d'un signal d'horloge d'un signal série en bande de base, comprenant :
- un circuit générateur d'impulsions adapté pour générer des impulsions à chaque transition, montante ou descendante, du signal série en bande de base ;
- une boucle à verrouillage de phase comprenant un oscillateur contrôlé en tension qui génère un signal de sortie d'oscillateur et un filtre délivrant un signal de consigne à l'oscillateur,
la boucle à verrouillage de phase comportant en outre un interrupteur intercalé entre l'oscillateur et le filtre dont la commutation est commandée par la sortie du circuit générateur d'impulsions, et en ce que le filtre est un filtre passe-bas, de telle sorte que :
- en présence d'une impulsion générée par le circuit générateur d'impulsions, l'interrupteur est fermé et le filtre moyenne alors le signal de sortie d'oscillateur traversant l'interrupteur pour délivrer le signal de consigne à l'oscillateur ;
- en absence d'une impulsion générée par le circuit générateur d'impulsions, l'interrupteur est ouvert et le filtre mémorise alors un signal de niveau constant pour délivrer le signal de consigne à l'oscillateur,
le dispositif étant caractérisé en ce qu'il comporte en outre une bascule de décision permettant de resynchroniser le signal série en bande de base en recopiant ledit signal à chaque front descendant du signal de sortie d'oscillateur.

Certains aspects préférés, mais non limitatifs, de ce dispositif sont les suivants :
- le circuit générateur d'impulsions génère des impulsions dont la durée correspond à une demi-période de l'élément binaire du signal série en bande de base ;
- le circuit générateur d'impulsions comprend une ligne à retard pour retarder le signal série en bande de base d'une demi-période de l'élément binaire dudit signal série en bande de base, et une porte logique OU-Exclusif permettant de comparer le signal série en bande de base et le signal série en bande de base retardé par la ligne à retard ;
- la ligne à retard est une ligne à constante répartie ;
- le circuit générateur d'impulsions est incorporé dans un circuit intégré monolithique ;
- le filtre passe-bas comporte des condensateurs adaptés :
   - une fois la boucle verrouillée, lorsque l'interrupteur est fermé, pour se charger si le signal de sortie d'oscillateur est à l'état haut ou se décharger si le signal de sortie d'oscillateur est à l'état bas, de manière à délivrer un signal de consigne moyen à l'oscillateur ;
   - lorsque l'interrupteur est ouvert, pour mémoriser la tension de manière à délivrer un signal de consigne constant à l'oscillateur ;
- le filtre passe-bas présente deux fréquences de coupure, une première fréquence de coupure basse assurant la fonction de mémorisation en cas d'absence de transition du signal série en bande de base et une seconde fréquence de coupure haute assurant le filtrage des bruits de phase du message reçu ;
- l'oscillateur est un oscillateur à quartz contrôlé en tension ;
- le signal série en bande de base est un signal NRZ ;
- le signal série en bande de base est reçu depuis une ligne de transmission véhiculant les fronts montants ou descendants du signal série en bande de base, et comprenant en outre un comparateur à hystérésis apte à reconstituer les états binaires du message du signal série en bande de base ; et
- le dispositif comprend en outre un inverseur permettant d'inverser le signal de sortie d'oscillateur pour obtenir l'horloge de référence pour l'échantillonnage du message de sortie resynchronisé.

Selon un second aspect, l'invention propose un système de transmission de données numériques sur une liaison série en base de base, comprenant un émetteur et un récepteur reliés par un canal de transmission, caractérisé en ce que le récepteur comprend un dispositif selon le premier aspect de l'invention.

D'autres aspects, buts et avantages de la présente invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma représentant un mode de réalisation possible du dispositif selon le premier aspect de l'invention ;
- la figure 2 représente des chronogrammes des différents signaux de la figure 1 ;
- la figure 3 représente un comparateur à hystérésis pouvant être utilisé dans le cadre de l'invention pour reconstituer les états binaires du message du signal série en bande de base.

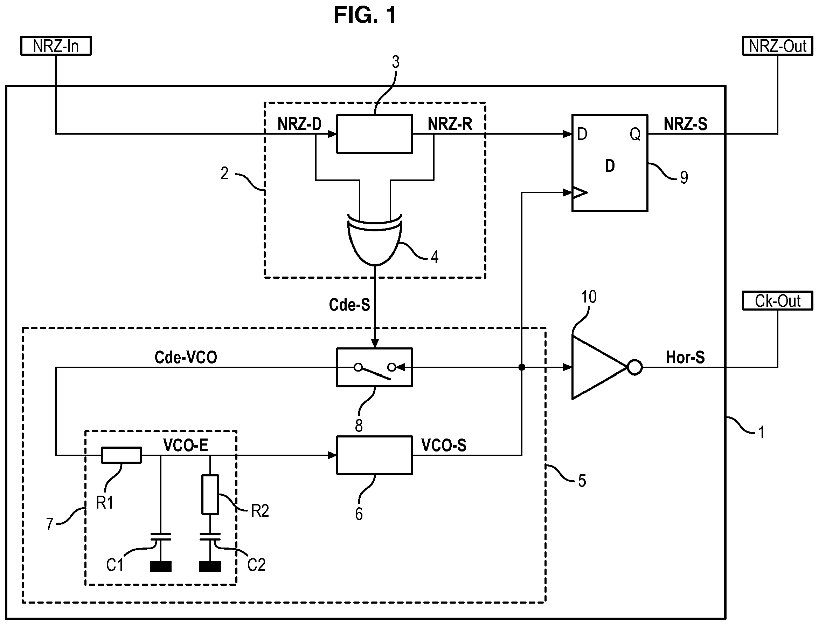

En référence à la figure 1, on a représenté un dispositif de reconstitution d'un signal d'horloge d'un signal série en bande de base 1 selon un mode de réalisation possible du premier aspect de l'invention.

Un tel dispositif 1 est typiquement destiné à être incorporé dans un récepteur relié par l'intermédiaire d'un canal de communication à un transmetteur. On précise ici que dans le cadre de transmission bidirectionnelle de données entre l'émetteur et le récepteur, l'émetteur incorpore également un dispositif de reconstitution d'horloge conforme au premier aspect de l'invention.

Dans le cadre de l'invention, le message série en bande de base dont les transitions vont être utilisée pour reconstituer son horloge est typiquement un message NRZ. L'invention n'est toutefois pas limitée à ce codage particulier, et à vocation à s'étendre à d'autre type de codage, et particulier à des codages ne présentant pas de transitions lors de séries de bits identiques.

Sur la figure 1, l'étiquette «NRZ-In» représente le message numérique série reçu NRZ-D disponible en entrée du dispositif de reconstitution d'horloge 1. Les étiquettes « NRZ-OUT » et « Ck-OUT » représentent quant à elles les sorties du dispositif de reconstitution d'horloge 1, à savoir respectivement le message numérique resynchronisé NRZ-S et l'horloge de référence Hor-S pour l'échantillonnage du message numérique reçu resynchronisé NRZ-S.

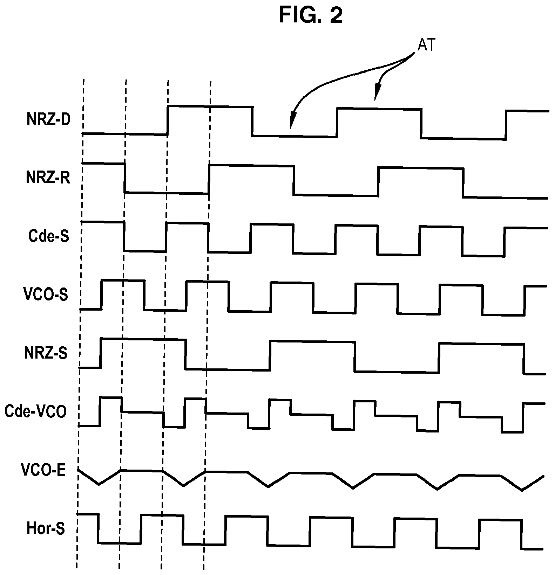

Comme représenté sur le chronogramme de la figure 2, le message numérique série reçu NRZ-D disponible en entrée du dispositif de reconstitution d'horloge est composé d'une suite d'états binaires présentant une absence de transitions AT lors d'une succession de bits identiques.

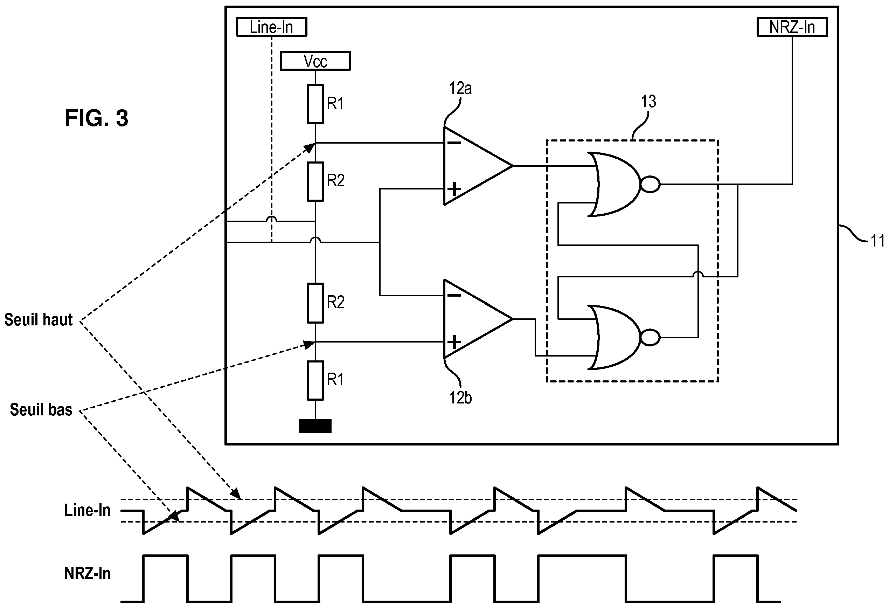

On précise ici que les états binaires peuvent ne pas être transmis sur le canal de communication entre l'émetteur et le récepteur, mais seulement leurs transitions. Le canal de communication véhicule ainsi les fronts montants ou descendants du signal série en bande de base. Dans un tel cas de figure, le dispositif de reconstitution d'horloge 1 comprend avantageusement un comparateur à hystérésis apte à reconstituer les états binaires du message du signal série en bande de base. Comme représenté sur la figure 3, le comparateur à hystérésis 11 peut notamment être réalisé par deux comparateurs simples 12a, 12b (le comparateur 12a comparant le signal reçu depuis le canal de communication « Line-In » avec un Seuil haut, le comparateur 12 comparant le signal reçu depuis le canal de communication « Line-In » avec un Seuil bas) suivis d'une bascule RS 13 assurant la mémorisation des états transitoires et fournissant le message NRZ-In.

Revenant à la figure 1, le dispositif de reconstitution d'horloge 1 comprend un circuit générateur d'impulsions 2 adapté pour générer des impulsions à chaque transition, montante ou descendante, du message reçu NRZ-D.

Selon un mode de réalisation possible, le circuit générateur d'impulsions 2 comprend une ligne à retard 3 pour retarder le message reçu NRZ-D d'une demi-période de l'élément binaire dudit message NRZ-D. La ligne à retard 3 fournit en sortie un message numérique reçu retardé d'un demi-bit NRZ-R (voir chronogramme sur la figure 2).

La ligne à retard 3 est préférentiellement une ligne à constante répartie (c'est-à-dire une ligne adaptée, dont la longueur dépend du retard désiré). Dans un tel cas de figure, le circuit générateur d'impulsions peut avantageusement être incorporé dans un circuit intégré monolithique.

La ligne à retard 3 peut également être constituée par une ligne à constantes localisées (sous la forme d'une suite de réseau LC), ou un registre à décalage échantillonné à cadence élevé, ou encore par mise en série de portes logiques élémentaires.

Le circuit générateur d'impulsions 2 comprend en outre une porte logique OU-Exclusif 4 permettant de comparer le message reçu NRZ-D et le message reçu retardé NRZ-R. Les transitions, montantes ou descendantes, du message reçu NRZ-D sont ainsi mises en évidence dans le message Cde-S disponible en sortie de la porte OU-Exclusif 4 par un état logique 1 d'une durée correspondant à un demi-période de l'élément binaire du message reçu.

Un chronogramme du message Cde-S, correspondant à la sortie du circuit générateur d'impulsions 2, est représenté sur la figure 2.

Le dispositif de reconstitution d'horloge 1 comprend en outre une boucle à verrouillage de phase 5 permettant de réaliser un asservissement se verrouillant en phase (une position stable sur 360°) au moment des transitions quand elles ont lieu (c'est-à-dire à des positions temporelles prédéterminées) mais qui peuvent être absentes lors de suites de 0 ou de 1 dans le message reçu NRZ-D. La boucle 5 est ainsi apte à reconstituer l'horloge bit d'un message NRZ, tout en supportant des absences de transitions. On notera que les inventeurs ont pu valider le bon fonctionnement du dispositif de reconstitution d'horloge malgré des absences de transitions portant jusqu'à 3000 bits consécutifs.

La boucle 5 comprend un oscillateur contrôlé en tension 6 (également dénommé VCO selon la dénomination anglo-saxonne Voltage Controlled Oscillator) qui génère un signal de sortie d'oscillateur VCO-S périodique dont la fréquence est proportionnelle à la tension appliquée sur son entrée, et un filtre 7 délivrant un signal de consigne VCO-E à l'oscillateur 6.

L'oscillateur 6 est de préférence un oscillateur à quartz contrôlé en tension (VCXO selon « Voltage Controlled Crystal Oscillator »). Un VCXO présente en effet une plage de fréquence d'émission très restreinte (inférieure à 1% de la fréquence centrale) et parfaitement connue.

La boucle 5 comporte en outre un interrupteur 8 intercalé entre l'oscillateur 6 et le filtre 7, dont la commutation est commandée par la sortie Cde-S du circuit générateur d'impulsions 2.

Quand la boucle est verrouillée en phase, une transition montante de la sortie de l'oscillateur VCO 6 se produit pendant la durée de conduction de l'interrupteur 8. En sortie de l'interrupteur 8, l'état électrique de la ligne varie entre :
- Haute impédance, interrupteur ouvert. Le filtre passe bas 7 conserve la mémoire analogique de la tension précédemment échantillonnée.
- Niveau logique 0 : valeur électrique proche de 0V.
- Niveau logique 1 : valeur électrique proche de la tension d'alimentation des circuits logiques (5V, 3.3V, 2.5V typiquement).

Quand l'interrupteur 8 est fermé, c'est-à-dire quand le circuit générateur d'impulsions 2 positionne le signal Cde-S à 1 (état actif), le filtre passe-bas 7 intègre une composante moyenne dépendante de l'erreur de phase du signal VCO-S sortant de l'oscillateur contrôlé 6. Si la phase se décale dans un sens, la tension moyenne augmente et la fréquence du signal VCO-S augmente aussi, si la phase se décale dans l'autre sens, la fréquence diminue. Ces décalages de fréquences impliquent des augmentations ou diminutions des composantes moyennes, tendant à faire converger le système vers une position stable, asservie en phase.

On relèvera ici que deux phases sont théoriquement stables (0° et 360°), mais qu'en réalité une seule l'est réellement. En effet, il s'agit dans un cas d'un équilibre convergent (un petit écart provoquera une tension poussant à retourner vers le point d'équilibre), et dans l'autre cas d'un équilibre divergent (un petit écart entraînera un déséquilibre encore plus important, et au final une rotation de 180° pour trouver l'équilibre stable et convergent).

En l'absence d'une impulsion générée par le circuit générateur d'impulsions 2, l'interrupteur 8 est ouvert et le filtre 7 mémorise alors un signal de niveau constant pour délivrer le signal de consigne VCO-E à l'oscillateur 6.

Plus précisément, le filtre passe-bas 7 comporte des éléments adaptés :
- une fois la boucle verrouillée, lorsque l'interrupteur 8 est fermé, pour se charger si le signal de sortie d'oscillateur VCO-S est à l'état haut ou se décharger si le signal de sortie d'oscillateur VCO-S est à l'état bas, de manière à délivrer un signal de consigne moyen à l'oscillateur ;
- lorsque l'interrupteur 8 est ouvert, pour mémoriser la tension de manière à délivrer un signal de consigne constant VCO-E à l'oscillateur.
- pour assurer une fonction de filtrage (réduction) du bruit de phase de l'horloge restituée vis-à-vis du bruit de phase du message entrant.

On notera que les essais réalisés par les inventeurs ont montré une forte insensibilité à l'absence de transitions (jusqu'à 3000 bits consécutifs), très au-delà des besoins réels, ainsi qu'une bonne capacité de réduction des bruits de phase en cas de chaînages successifs de coupleurs du même type.

On notera également que l'impédance d'entrée du VCO 6 étant considérée comme infinie, celle-ci est sans impact sur la charge ou la décharge des condensateurs du filtre 7.

Le filtre passe bas 7 permettant d'atteindre ces performances présente deux fréquences de coupure. Il s'agit par exemple d'un filtre passif du premier ordre.

Une première fréquence de coupure est liée aux éléments R1 et C2 (coupure très basse fréquence). C'est cette première fréquence de coupure basse fréquence qui assure principalement la fonction de mémorisation « long terme » en cas d'absence de transition du message reçu. A titre d'exemple, un très bon compromis a été atteint par la Demanderesse avec une coupure basse réalisée avec un réseau RC composé de résistances 1kohms (R1) et 499ohms (R2) et un condensateur de 2,2µF (C2). Dans ces conditions, la résistance à l'absence de transitions binaires est d'au moins 3000 bits pour un message à 25Mbits/s. Les valeurs annoncées doivent préférentiellement être respectées avec une tolérance meilleure que 20%.

Un réseau atténuateur (R1 et R2) autorise un gain de boucle résiduel suffisant jusqu'à la deuxième fréquence de coupure (haute fréquence) liée à R1 et C1. C'est cette deuxième fréquence de coupure qui permet de réaliser le meilleur compromis entre stabilité (marge de phase) et vitesse de comportement sur les transitoires, en assurant principalement le filtrage des bruits de phase du message reçu.

La fréquence de coupure haute permet en effet de limiter le gain de boucle en haute fréquence avec pour objectif de restituer un message conforme au précédent avec un bruit de phase atténué. La Demanderesse a recherché le meilleur au regard des critères de stabilité de la boucle (marge de phase), vitesse de ralliement et réduction de bruit maximisés. Les valeurs qui ont donné un très bon compromis sont de 1kohms (R1) et 22nF (C1), avec une tolérance préférentiellement meilleure que 20%.

La figure 2 représente les chronogrammes :
- du message Cde-S en sortie du circuit générateur d'impulsions servant de commande pour l'ouverture et la fermeture de l'interrupteur 8 ;
- du message Cde-VCO correspondant au signal de consigne de l'oscillateur 6 avant filtrage ;
- du message VCO-E correspondant au signal de consigne de l'oscillateur 6 après filtrage ;
- du message VCO-S correspondant à la sortie de l'oscillateur 6.

Comme indiqué précédemment, le message Cde-S présente une impulsion suite à une transition du message reçu NRZ-D.

Le message Cde-VCO est ainsi à la valeur mémorisée en C1 et C2 en absence d'une impulsion (l'interrupteur 8 est alors ouvert), tandis qu'il recopie la sortie VCO-S de l'oscillateur en présence d'une impulsion (l'interrupteur 8 est alors fermé).

Le message VCO-E en sortie du filtre 7 est ainsi constant lorsque le message Cde-S est inactif (état bas) en absence d'une transition (le filtre jouant alors, via ses condensateurs, le rôle d'une mémoire analogique apte à mémoriser et à délivrer un signal de consigne constant à l'oscillateur), tandis que le filtre 7 délivre une tension de commande moyenne à l'oscillateur lorsque le message Cde-VCO recopie la sortie VCO-S de l'oscillateur (le filtre jouant alors, via la charge et la décharge des condensateurs, le rôle d'un filtre passe-bas permettant de fournir une tension stable à l'oscillateur).

Dans la mesure où une tension de commande stable est délivrée par le filtre (dans sa fonction passe-bas) à l'oscillateur, la fonction passe-bas du filtre 7 permet en outre d'obtenir une fréquence à faibles bruits de phase et d'amplitude en sortie de l'oscillateur 6, ce qui permet après échantillonnage de restituer un message NRZ à bruits de phase plus réduits que l'original.

Le dispositif de reconstitution d'horloge 1 comporte en outre une bascule de décision 9 permettant de resynchroniser le signal série reçu.

Comme représenté sur la figure 1, la bascule de décision 9 recopie sur la sortie Q (message de sortie NRZ-S dont le chronogramme est représenté sur la figure 2) le signal disponible sur l'entrée D (message reçu retardé NRZ-R) à chaque front descendant du signal de sortie d'oscillateur VCO-S.

Le dispositif de reconstitution d'horloge 1 comporte en outre un inverseur 10 (porte logique NON) permettant d'inverser le signal de sortie d'oscillateur VCO-S pour obtenir l'horloge de référence Hor-S pour l'échantillonnage du message de sortie resynchronisé NRZ-S.

Outre sa fonction de reconstitution de l'horloge bit du message numérique série reçu supportant des absences de transition, et sa fonction de régénération du message numérique série reçu en diminuant les bruits de phase et d'amplitude, le dispositif selon le premier aspect de l'invention présente les avantages suivants :
- il est relativement simple et facilement reproductible ;
- il peut être implémenté en ASIC ou FPGA mixte (analogique et numérique) ;
- il peut fonctionner à des cadences élevées (plusieurs dizaines de MHz) ;
- il ne met pas en oeuvre de composants complexes, et est ainsi facilement justifiable au regard de la norme aéronautique DO254.

On a dans ce qui précède décrit une implémentation analogique du dispositif selon le premier aspect de l'invention. L'invention n'est toutefois pas limitée à ce type d'implémentation et peut à cet égard être mise en oeuvre dans une version complètement numérique (registre à décalage pour la fonction retard, oscillateur VCO numérique, filtre passe-bas 7 remplacé par un accumulateur numérique). On retiendra que cette version numérique est plus spécifiquement destinée aux applications basse fréquence (par exemple jusqu'à 1Mbits/s).

On précise par ailleurs que l'invention n'est pas limitée à un dispositif selon son premier aspect, mais s'étend également à un système de transmission de données numériques sur une liaison série en base de base, comprenant un émetteur et un récepteur reliés par un canal de transmission, où le récepteur comprend un dispositif selon le premier aspect de l'invention.

Un tel système est par exemple un système avionique reliant un contrôleur central (émetteur) à un ou plusieurs périphériques distants du type capteurs ou actionneurs de commande de vol (récepteurs) par l'intermédiaire d'un canal de communication. Le canal de communication peut notamment être un canal de communication de données bidirectionnel. La ligne reliant le contrôleur au périphérique peut en outre être mutualisée pour la transmission de puissance électrique et de données bidirectionnelles.

## Revendications

1. Dispositif (1) de reconstitution d'un signal d'horloge d'un signal série en bande de base (NRZ-D), comprenant :
• un circuit générateur d'impulsions (2) adapté pour générer des impulsions à chaque transition, montante ou descendante, du signal série en bande de base (NRZ-D);
• une boucle à verrouillage de phase (5) comprenant un oscillateur contrôlé en tension (6) qui génère un signal de sortie d'oscillateur (VCO-S) et un filtre (7) délivrant un signal de consigne (VCO-E) à l'oscillateur (6), la boucle à verrouillage de phase (5) comportant en outre un interrupteur (8) intercalé entre l'oscillateur (6) et le filtre (7) dont la commutation est commandée par la sortie (Cde-S) du circuit générateur d'impulsions (2), et en ce que le filtre (7) est tel que :
- en présence d'une impulsion générée par le circuit générateur d'impulsions (2), l'interrupteur (8) est fermé et le filtre (7) moyenne alors le signal de sortie d'oscillateur (VCO-S) traversant l'interrupteur pour délivrer le signal de consigne (VCO-E) à l'oscillateur ;
- en absence d'une impulsion générée par le circuit générateur d'impulsions (2), l'interrupteur (8) est ouvert et le filtre (7) mémorise alors un signal de niveau constant pour délivrer le signal de consigne (VCO-E) à l'oscillateur ;
le dispositif étant **caractérisé en ce que** le filtre comporte un réseau RC qui est composé de deux résistances (R1, R2) et d'un condensateur (C2),
ledit filtre comportant en outre un deuxième condensateur (C1), les condensateurs du filtre étant aptes à mémoriser et délivrer un signal de consigne constant (VCO-E) à l'oscillateur en absence de transition de la sortie (Cde-S) du générateur d'impulsions,
le réseau RC correspondant à une première fréquence de coupure basse,
les résistances du filtre autorisant un gain de boucle résiduel jusqu'à une deuxième fréquence de coupure du filtre liée au deuxième condensateur et à l'une des résistances.

2. Dispositif selon la revendication 1, dans lequel le réseau RC est configurée pour assurer une résistance à l'absence de transitions d'au moins 3000 bits consécutifs d'un signal série en bande de base disposant d'un débit de 25Mbits/s.

3. Dispositif selon la revendication 1, dans lequel le circuit générateur d'impulsions (2) est configuré pour générer des impulsions dont la durée correspond à une demi-période de l'élément binaire du signal série en bande de base (NRZ-D).

4. Dispositif selon la revendication 3, dans lequel le circuit générateur d'impulsions (2) comprend une ligne à retard (3) pour retarder le signal série en bande de base (NRZ-D) d'une demi-période de l'élément binaire dudit signal série en bande de base, et une porte logique OU-Exclusif (4) permettant de comparer le signal série en bande de base (NRZ-D) et le signal série en bande de base retardé (NRZ-R) par la ligne à retard (3).

5. Dispositif selon la revendication 4, dans lequel la ligne à retard (3) est une ligne à constante répartie.

6. Dispositif selon la revendication 5, dans lequel le circuit générateur d'impulsions (2) est incorporé dans un circuit intégré monolithique.

7. Dispositif selon l'une des revendications précédentes, dans lequel le filtre (7) comporte des condensateurs adaptés :
• une fois la boucle verrouillée, lorsque l'interrupteur est fermé, pour se charger si le signal de sortie d'oscillateur est à l'état haut ou se décharger si le signal de sortie d'oscillateur est à l'état bas, de manière à délivrer un signal de consigne moyen à l'oscillateur ;
• lorsque l'interrupteur est ouvert, pour mémoriser la tension de manière à délivrer un signal de consigne constant à l'oscillateur.

8. Dispositif selon l'une des revendications précédentes, **caractérisé en ce qu'**il comporte en outre une bascule de décision (9) permettant de resynchroniser le signal série en bande de base en recopiant ledit signal à chaque front montant du signal de sortie d'oscillateur (VCO-S).

9. Dispositif selon l'une des revendications précédentes, **caractérisé en ce que** l'oscillateur est un oscillateur à quartz contrôlé en tension.

10. Dispositif selon l'une des revendications précédentes, dans lequel le signal série en bande de base est un signal NRZ.

11. Dispositif selon l'une des revendications précédentes, comprenant en outre un comparateur à hystérésis apte à reconstituer les états binaires du message du signal série en bande de base.

12. Dispositif selon la revendication 11, comprenant en outre un inverseur (10) permettant d'inverser le signal de sortie d'oscillateur (VCO-S) pour obtenir l'horloge de référence (Hor-S) pour l'échantillonnage du message de sortie resynchronisé (NRZ-S).

13. Système de transmission de données numériques sur une liaison série en base de base, comprenant un émetteur et un récepteur reliés par un canal de transmission, **caractérisé en ce que** le récepteur comprend un dispositif (1) selon l'une quelconque des revendications précédentes.

## Patentansprüche

1. Vorrichtung (1) zum Rekonstruieren eines Taktsignals eines Basisband-Reihensignals (NRZ-D), umfassend:
• eine Impulsgeneratorschaltung (2), die geeignet ist, um bei jedem aufsteigendem oder abfallenden Übergang des Basisband-Reihensignals (NRZ-D) Impulse zu generieren;
• eine Phasenregelschleife (5), umfassend einen spannungsgesteuerten Oszillator (6), der ein Oszillatorausgangssignal (VCO-S) generiert, und einen Filter (7), der dem Oszillator (6) ein Sollsignal (VCO-E) bereitstellt, wobei die Phasenregelschleife (5) ferner einen Schalter (8) zwischen dem Oszillator (6) und dem Filter (7) aufweist, dessen Umschaltung von dem Ausgang (Cde-S) der Impulsgeneratorschaltung (2) gesteuert wird, und dass der Filter (7) derart ist, dass:
- bei Vorliegen eines von der Impulsgeneratorschaltung (2) generierten Impulses der Schalter (8) geschlossen ist und der Filter (7) dann das Oszillatorausgangssignal (VCO-S), welches den Schalter durchquert, mittelt, um dem Oszillator das Sollsignal (VCO-E) bereitzustellen;
- bei Abwesenheit eines von der Impulsgeneratorschaltung (2) generierten Impulses der Schalter (8) geöffnet ist und der Filter (7) dann ein Konstantniveausignal speichert, um dem Oszillator das Sollsignal (VCO-E) bereitzustellen;
wobei die Vorrichtung **dadurch gekennzeichnet ist, dass** der Filter ein RC-Netz aufweist, das aus zwei Widerständen (R1, R2) und von einem Kondensator (C2) zusammengesetzt ist, wobei der Filter ferner einen zweiten Kondensator (C1) aufweist, wobei die Kondensatoren des Filters imstande sind, dem Oszillator bei Abwesenheit eines Übergangs des Ausgangs (Cde-S) des Impulsgenerators ein Konstantniveausignal (VCO-E) bereitzustellen und zu speichern,
wobei das RC-Netz einer ersten niedrigen Sperrfrequenz entspricht, wobei die Widerstände des Filters eine Restschleifenverstärkung bis auf eine zweite Sperrfrequenz des Filters erlauben, die mit dem zweiten Kondensator und mit einem der Widerstände verbunden ist.

2. Vorrichtung nach Anspruch 1, wobei das RC-Netz konfiguriert ist, um bei Abwesenheit von Übergängen von mindestens 3000 aufeinanderfolgenden Bits eines Basisband-Reihensignals, das über einen Durchsatz von 25 Mbits/s verfügt, einen Widerstand zu sichern.

3. Vorrichtung nach Anspruch 1, wobei die Impulsgeneratorschaltung (2) konfiguriert ist, um Impulse zu generieren, deren Dauer einer halben Periode des binären Elements des Basisband-Reihensignals (NRZ-D) entspricht.

4. Vorrichtung nach Anspruch 3, wobei die Impulsgeneratorschaltung (2) eine Verzögerungsleitung (3) umfasst, um das Basisband-Reihensignal (NRZ-D) um eine halbe Periode des binären Elements des Basisband-Reihensignals zu verzögern, und einen logischen Port Exklusiv-ODER (4), der erlaubt, das Basisband-Reihensignal (NRZ-D) und das von der Verzögerungsleitung (3) verzögerte Basisband-Reihensignal (NRZ-R) zu vergleichen.

5. Vorrichtung nach Anspruch 4, wobei die Verzögerungsleitung (3) eine Leitung mit verteilter Konstante ist.

6. Vorrichtung nach Anspruch 5, wobei die Impulsgeneratorschaltung (2) in einen monolithischen integrierten Schaltkreis inkorporiert ist.

7. Vorrichtung nach einem der vorangehenden Ansprüche, wobei der Filter (7) Kondensatoren aufweist, die geeignet sind:
• sobald die Schleife verriegelt ist, wenn der Schalter geschlossen ist, sich zu laden, wenn das Oszillatorausgangssignal hoch steht ist oder sich zu entladen, wenn das Oszillatorausgangssignal niedrig steht, um dem Oszillator ein mittleres Sollsignal bereitzustellen;
• wenn der Schalter geöffnet ist, die Spannung zu speichern, um dem Oszillator ein konstantes Sollsignal bereitzustellen.

8. Vorrichtung nach einem der vorangehenden Ansprüche, **dadurch gekennzeichnet, dass** sie ferner eine Entscheidungswippe (9) aufweist, die erlaubt, das Basisband-Reihensignal durch Kopieren des Signals in jede aufsteigende Front des Oszillatorausgangssignals (VCO-S) neu zu synchronisieren.

9. Vorrichtung nach einem der vorangehenden Ansprüche, **dadurch gekennzeichnet, dass** der Oszillator ein spannungsgesteuerter Quarzoszillator ist.

10. Vorrichtung nach einem der vorangehenden Ansprüche, wobei das Basisband-Reihensignal ein NRZ-Signal ist.

11. Vorrichtung nach einem der vorangehenden Ansprüche, umfassend ferner einen Komparator mit Hysterese, der imstande ist, die Binärzustände der Nachricht des Basisband-Reihensignals zu rekonstruieren.

12. Vorrichtung nach Anspruch 11, umfassend ferner einen Wechselrichter (10), der erlaubt, das Oszillatorausgangssignal (VCO-S) umzukehren, um den Referenztakt (Hor-S) für das Sampling der neu synchronisierten Ausgangsnachricht (NRZ-S) zu erhalten.

13. System für die Übertragung von digitalen Daten über eine Basisband-Reihenverbindung, umfassend einen Sender und einen Empfänger, die über einen Übertragungskanal verbunden sind, **dadurch gekennzeichnet, dass** der Empfänger eine Vorrichtung (1) nach einem der vorangehenden Ansprüche umfasst.

## Claims

1. A device (1) for reconstructing a clock signal of a baseband serial signal (NRZ-D), comprising:
• a pulse generator circuit (2) designed to generate pulses at each transition, whether rising or falling, of the baseband serial signal (NRZ-D);
• a phase-locked loop (5) comprising a voltage-controlled oscillator (6) which generates an oscillator output signal (VCO-S) and a filter (7) providing a setpoint signal (VCO-E) to the oscillator (6), the phase-locked loop (5) also including a switch (8) inserted between the oscillator (6) and the filter (7) whose switching is controlled by the output (Cde-S) of the pulse generator circuit (2), and in which the filter (7) is such that:
- in the presence of a pulse generated by the pulse generator circuit (2), the switch (8) is closed and the filter (7) then averages the oscillator output signal (VCO-S) passing through the switch to provide the setpoint signal (VCO-E) to the oscillator;
- in the absence of a pulse generated by the pulse generator circuit (2), the switch (8) is open and the filter (7) then stores a constant level signal to deliver the setpoint signal (VCO-E) to the oscillator;
the device being **characterized in that** the filter (7) includes an RC network which is composed of two resistors (R1, R2) and of a capacitor (C2), said filter further including a second capacitor (C1), the capacitors of the filter being capable of storing and providing a constant setpoint signal (VCO-E) to the oscillator in the absence of transitions of the output (Cde-S) of the pulse generator,
the RC network corresponding to a first, low cutoff frequency, the resistors of the filter authorizing a residual loop gain to a second cutoff frequency of the filter, linked to the second capacitor and to one of the resistors.

2. The device according to claim 1, wherein the RC network is configured to ensure a resistance, in the absence of transitions, of at least 3000 consecutive bits of a baseband serial signal with a 25Mbits/s rate.

3. The device according to claim 1, wherein the pulse generator circuit (2) is configured to generate pulses whose duration corresponds to a half-period of the data bit of the baseband serial signal (NRZ-D).

4. The device according to claim 3, wherein the pulse generator circuit (2) comprises a delay line (3) to delay the baseband serial signal (NRZ-D) by one half-period of the data bit of said baseband serial signal, and an Exclusive-OR logic gate (4) allowing comparison of the baseband serial signal (NRZ-D) with the baseband serial signal (NRZ-R) delayed by the delay line (3).

5. The device according to claim 4, wherein the delay line (3) is a distributed constant line.

6. The device according to claim 5, wherein the pulse generator circuit (2) is incorporated into a monolithic integrated circuit.

7. The device according to any of the preceding claims, wherein the filter (7) includes capacitors designed:
• once the loop is locked, when the switch is closed, to charge if the oscillator output signal is in the high state, or to discharge if the oscillator output signal is in the low state, so as to deliver an average setpoint signal to the oscillator;
• when the switch is open, to store the voltage so as to provide a constant setpoint signal to the oscillator.

8. The device according to any of the preceding claims, **characterized in that** it further includes a flip-flop (9) allowing the baseband serial signal to be resynchronized by duplicating said signal at each rising edge of the oscillator output signal (VCO-S).

9. The device according to any of the preceding claims, **characterized in that** the oscillator is a voltage-controlled quartz oscillator.

10. The device according to any of the preceding claims, wherein the baseband serial signal is an NRZ signal.

11. The device according to any of the preceding claims, further comprising a hysterisis comparator capable of reconstructing the binary states of the message of the baseband serial signal.

12. The device according to claim 11, further comprising an inverter (10) allowing inversion of the oscillator output signal (VCO-S) to obtain the reference clock (Hor-S) for sampling the resynchronized output message (NRZ-S).

13. A system for transmitting digital data over a baseband serial link, comprising a transmitter and a receiver connected by a transmission channel, **characterized in that** the receiver comprises a device (1) according to any one of the preceding claims.
